**Europäisches Patentamt**

**European Patent Office**

**Office européen des brevets**

(19)

(11) Veröffentlichungsnummer: **0 012 919**
**B1**

(12) **EUROPÄISCHE PATENTSCHRIFT**

(45) Veröffentlichungstag der Patentschrift: **24.08.83**

(21) Anmeldenummer: **79105075.0**

(22) Anmeldetag: **10.12.79**

(51) Int. Cl.³: **H 02 M 1/06,**
**H 03 K 17/04, H 02 M 1/18**

(54) Schaltungsanordnung zum Herabsetzen der Freiwerdezeit eines Thyristors.

(30) Priorität: **29.12.78 DE 2856780**

(43) Veröffentlichungstag der Anmeldung:
**09.07.80 Patentblatt 80/14**

(45) Bekanntmachung des Hinweises auf die Patenterteilung:
**24.08.83 Patentblatt 83/34**

(84) Benannte Vertragsstaaten:
**FR GB IT SE**

(56) Entgegenhaltungen:
**BE - A - 723 250**
**DE - B - 1 255 206**
**GB - A - 1 174 086**
**US - A - 3 213 349**
**US - A - 3 614 531**
**US - A - 3 943 430**

(73) Patentinhaber: **SIEMENS AKTIENGESELLSCHAFT**
**Berlin und München Wittelsbacherplatz 2**
**D-8000 München 2 (DE)**

(72) Erfinder: **Lehmann, Erhard, Dipl.-Ing.**
**Römerstrasse 58**
**D-8011 Aschheim (DE)**
Erfinder: **Köhler, Siegfried**
**Michl-Ehbauer-Ring 19 a**
**D-8031 Puchheim (DE)**

Schaltungsanordnung zum Herabsetzen der Freiwerdezeit eines Thyristors

Die vorliegende Anmeldung bezieht sich auf eine Schaltungsanordnung zum Herabsetzen der Freiwerdezeit eines Thyristors, dem ein Gleichrichter antiparallelgeschaltet ist.

Bei Gleichstromstellern, Umrichtern usw. mit Thyristoren werden diesen zum Umkommutieren des Stroms sogenannte Freilaufdioden antiparallelgeschaltet, die einen Energieausgleich im Steller- oder Umrichtersystem innerhalb des durch die Stellfrequenz oder Umrichfrequenz vorgegebenen Zeitraums möglich machen. Beim Umkommutieren des Stroms liegt damit am Thyristor eine Sperrspannung in Rückwärtsrichtung an, die gleich dem Spannungsabfall der Diode ist. Dieser Spannungsabfall kann dynamisch etwa 10 V für die Dauer von einigen Mikrosekunden betragen und geht dann in den statischen Wert von ca. 1,5...2,0 V über. Diese geringe Gegenspannung am Thyristor bringt im Vergleich zu einer negativen Sperrspannung von mindestens 100 V eine drastische Verschlechterung der Freiwerdezeit des Thyristors mit sich.

Der Erfindung liegt die Aufgabe zugrunde, eine Schaltungsanordnung der eingangs erwähnten Art so zu verbessern, daß die Freiwerdezeit gegenüber der Lösung mit einer antiparallelgeschalteten Diode spürbar verbessert wird.

Die Erfindung ist dadurch gekennzeichnet, daß der Gleichrichter ein weiterer Thyristor ist, daß diesem ein RC-Glied derart parallelgeschaltet ist, daß ein Anschluß des Widerstands mit der Anode und ein Anschluß des Kondensators mit der Katode verbunden ist, und daß eine Diode vorgesehen ist, deren Anode mit dem Verbindungspunkt von Widerstand und Kondensator und deren Katode mit dem Steueranschluß des weiteren Thyristors verbunden ist.

Vorteilhafterweise wird als RC-Glied ein als Schutzschaltung für den ersten Thyristor vorgesehenes RC-Glied verwendet.

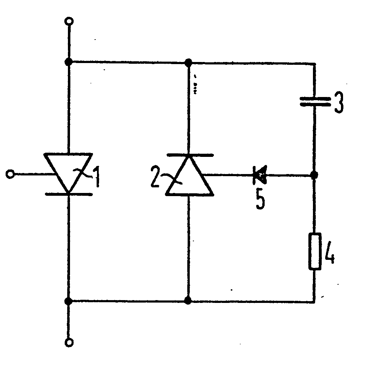

In der Figur ist ein Ausführungsbeispiel der Erfindung dargestellt. Der Thyristor 1, im folgenden als erster Thyristor bezeichnet, ist zum Beispiel in einem Zweig eines Gleichstromstellers oder eines Umrichters eingeschaltet. Dem ersten Thyristor 1 ist der weitere Thyristor 2, im folgenden als zweiter Thyristor bezeichnet, antiparallelgeschaltet. Er kann in seinen Daten dem ersten Thyristor 1 identisch sein oder auch kleinere Leistung aufweisen. Dem zweiten Thyristor 2 ist ein RC-Glied parallelgeschaltet, das aus einem Kondensator 3 und einem Widerstand 4 besteht. Der Kondensator 3 ist mit der Katode und der Widerstand 4 mit der Anode des zweiten Thyristors 2 verbunden. Mit dem Verbindungspunkt zwischen Kondensator 3 und Widerstand 4 ist die Anode einer Diode 5 verbunden, deren Katode am Steueranschluß des zweiten Thyristors 2 liegt.

Zur Erläuterung der Wirkungsweise sei angenommen, daß die am ersten Thyristor 1 anliegende Spannung von positiven Werten Kommend durch Null gegen negative Werte geht und der Strom abkommutiert wird. Beim Abriß des Rückstroms baut sich somit am Thyristor 1 eine negative Spannung auf, die zu einem Abbau der im Thyristor 1 gespeicherten Ladungsträger führt. Entsprechend dem Spannungsanstieg gegen negative Werte fließt ein Strom über den Widerstand 4 und die Diode 5 in den Steuereingang des zweiten Thyristors 2. Erreicht dieser strom den zum Zünden des Thyristors 2 erforderlichen Wert, so wird dieser leitend und kann den zum Energieausgleich in der Steller- oder Umrichterschaltung notwendigen Strom führen. Im Normalfall steigt die positive Spannung bis zur Zündung am Thyristor 2 auf ca. 10 oder einige 10 V an, um dann innerhalb von 10 und mehr Mikrosekunden auf den statischen Durchlaßspannungsabfall von ca. 1,5...2,0 V abzufallen. Im Vergleich zur Schaltung mit antiparalleler Diode steht hier somit am Thyristor 1 eine höhere, langsamer abfallende Spannung in Sperrichtung an, wodurch die Freiwerdezeit günstig beeinflußt beziehungsweise kleiner wird. Entsprechend der Stromübernahme durch den zweiten Thyristor 2 hört der durch den Thyristor 1 fließende Rückstrom auf. Ist die Zündverzugszeit des Thyristors 2 entsprechend groß, läßt sich ein sanftes Abklingen des Rückstroms im Thyristor 1 erreichen.

Der Thyristor 2 und die Diode 5 sind gegen steile Spannungsspitzen durch den Kondensator 3 geschützt. Damit wird eine übermäßige Beanspruchung der Diode 5 und der Basis-Katodenstrecke des Thyristors 2 vermieden.

Als RC-Kombination kann eine RC-Kombination vorgesehen werden, die zum Schutz des Thyristors 1 gegen steile Spannungs- und Stromflanken in manchen Schaltungen vorgesehen sein muß. Eine übliche RC-Beschaltung für einen mittelgroßen Thyristor hat zum Beispiel Werte von ca. 10 Ohm, 0,25 $\mu$F. Mit einer solchen Schaltungsanordnung ließ sich gegenüber der Verwendung einer normalen antiparallelgeschalteten Diode eine Verkürzung der Freiwerdezeit um ca. 15% erreichen.

**Patentansprüche**

1. Schaltungsanordnung zum Herabsetzen der Freiwerdezeit eiens Thyristors (1), dem ein Gleichrichter (2) antiparallelgeschaltet ist, dadurch gekennzeichnet, daß der Gleichrichter ein weiterer Thyristor (2) ist, daß diesem ein RC-Glied (3, 4) derart parallelgeschaltet ist, daß ein Anschluß des Widerstands (4) mit der Anode und ein Anschluß des Kondensators (3) mit der Katode verbunden ist, und daß eine Diode (5) vorgesehen ist, deren Anode mit dem Verbindungspunkt von Widerstand (4) und Kondensator (3) und deren Katode mit dem Steueranschluß des weiteren Thyristors (2) verbunden ist.

2. Schaltungsanordnung nach Anspruch 1, dadurch gekennzeichnet, daß als RC-Glied ein als Schutzschaltung für den Thyristor (1) vorgesehenes RC-Glied verwendet wird.

**Revendications**

1. Circuit pour réduire le temps de récupération d'un thyristor (1), sur lequel un redresseur (2) est monté en antiparallèle, caractérisé par le fait que le redresseur est un autre thyristor (2), qu'en parallèle sur celui-ci un élément RC (3, 4) est monté de manière qu'une borne de la résistance (4) soit reliée à l'anode et une borne de condensateur (3) soit reliée à la cathode, qu'est prévue une diode (5) dont l'anode est reliée au point de jonction de la résistance (4) et de condensateur (3) et dont la cathode est reliée à la borne de commande de l'autre thyristor (2).

2. Circuit suivant la revendication 1, caractérisé par le fait qu'on utilise comme élément RC un élément RC prévu comme circuit de protection pour le thyristor (1).

**Claims**

1. A circuit arrangement for reducing the recovery time of a thyristor (1) to which a rectifier (2) is connected anti-parallel, characterised in that the rectifier is further thyristor (2) and an RC-element (3, 4) is connected in parallel to the latter in such manner that a terminal of the resistor (4) is connected to the anode and a terminal of the capacitor (3) is connected to the cathode, and that there is provided a diode (5) whose anode is connected to the junction point of the resistor (4) and the capacitor (3) and whose cathode is connected to the control terminal of the further thyristor (2).

2. A circuit arrangement as claimed in Claim 1, characterised in that the RC-element is an RC-element provided as a protection circuit for the thyristor (1).